# EUROPEAN PATENT SPECIFICATION

(11) **EP 0 294 614 B1**
(45) Date of publication and mention of the grant of the patent: **16.08.1995**
(21) Application number: 88107734.1
(22) Date of filing: 13.05.1988
(51) Int. Cl.: H03M 7/20

(54) **m bit to n bit code converting circuit**
Schaltung zur Umsetzung eines m bit Kodes in einen n bit Kode
Circuit pour la conversion d'un code à m bit en un code à n bit

(30) Priority: 15.05.1987 JP 119821/87
(43) Date of publication of application: 14.12.1988
(73) Proprietor: FUJITSU LIMITED, Kawasaki-shi, Kanagawa 211 (JP)
(72) Inventor: Hongo, Yoshiyuki, Kawasaki-shi Kanagawa, 213 (JP); Takatsu, Kazuo, Kawaguchi-shi Saitama, 332 (JP); Otsuka, Masanori, Itoshima-gun Fukuoka, 819-11 (JP)
(74) Representative: Lehn, Werner, Dipl.-Ing.

(56) References cited:
- PATENT ABSTRACTS OF JAPAN vol. 10, no. 221 (E-424)(2277), 2 August 1986 & JP-A-6158326

## Description

The present invention relates to an mBnB code converting circuit which converts m bits code to n bits code or reversely converts these codes.

In the PCM communication technology, the digital code conversion plays an important role and the code conversion is carried out to make the mark ratio of the digital code to be transmitted to 1/2, for instance.

It is a requirement that such code conversion processing is improved in its processing rate.

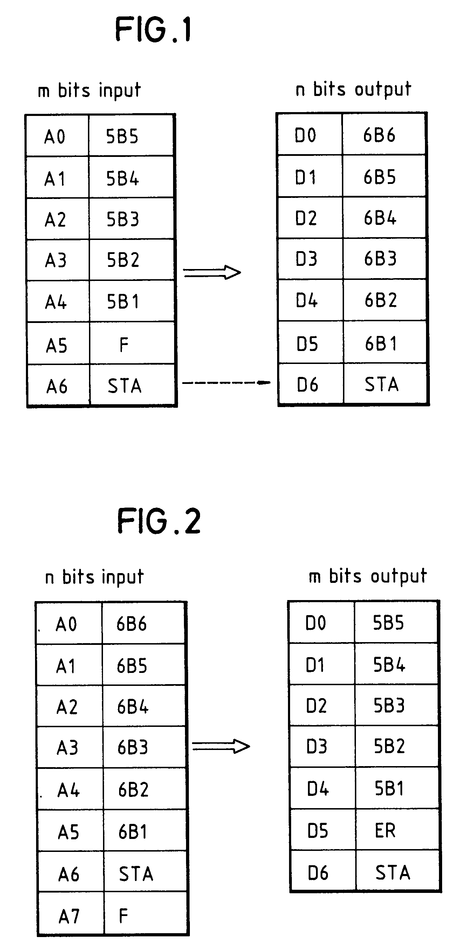

The mBnB code converting circuit, which converts the m bits code to the n bits code (m < n) in the transmitting side and also converts the n bits codes to the original m bits code in the receiving side through reverse conversion, has employed in the digital transmitting system to prevent from continuing zero bits for bit sequence independency, so-called BSI. For instance, in the conversion of 5B code and 6B code where m = 5 and n= 6 (5B6B conversion), the code conversion rules are shown in Fig. 1 and Fig. 2.

Fig. 1 indicates the conversion from 5B code to 6B code. A code A6 is a status bit STA, a code A5 is a frame bit F, codes A4 to A0 are bits 5B1 to 5B5 of input 5 bits data. When a frame bit F is "1", it means that codes A4 to A0 are the frame bits and following outputs can be obtained, D0 = 0, D1 = A0, D2 = A1, D3 = A2, D4 = A3, D5 = A4, D6 = A6. When a frame bit F is "0", it does not mean that codes A4 to A0 are the frame bits and outputs D5 to D0 become the bits 6B1 to 6B6 of the output 6B code while output D6 indicates disparity. When D6 = A6, disparity becomes 0, while D6 is equal to inversion of A6, disparity becomes ±2. In case the mark ratio of 5B code is 2/5, it is converted to the 6B code where "1" is added to the 5 bits as the last bit and in case the mark ratio is 3/5, it is converted to 6B code of 6 bits where "0" is added to the 5 bits as the last bit. Thereby, the mark ratio of 6B code becomes 3/6. In case the mark ratio is other value than 2/5 and 3/5, the 5B code is converted to the 6B code with the mark ratio of 4/6 or 2/6.

Fig. 2 indicates the conversion from 6B code to 5B code. A code A7 is a frame bit F, A6 is the status bit STA, and A5 to A0 are bits 6B1 to 6B6 of input 6 bits data. A code D6 is a status bit STA, D5 is an error bit ER, D4 to D0 are 5B1 to 5B5 bits of output 5 bits data.

When an input A7 is "1" indicating input 6 bits are the frame bits, outputs become as follows; D0 = A1, D1 = A2, D2 = A3, D3 = A4, D4 = A5, D5 = 0, D6 = A6.

When an input A7 is "0" indicating nonframe, if inputs A0 to A5 can be found in the code rule, the 6B code of inputs A0 to A5 are converted to the 5B code of outputs D0 to D4. When disparity is 0, the input A6 = 0, D6 = D5 = 0. When disparity is +2, D6 = 1, D5 = 0. When disparity is -2, D6 = 0, D5 0 1 resulting in an error. When disparity is 0, the input A6 = 1, D6 = 1, D5 = 0. When disparity is +2, D6 = D5 = 1, resulting in an error. Meanwhile, when disparity is -2, D6 = D5 = 0. When the inputs A0 to A5 cannot be found in the code rule, the outputs are assumed as D0 = 1, D1 = 0, D2 = 1, D3 = 0, D4 = 1, D5 = 1. In addition, D6 is 0 when the mark ratio is 0/6 or 1/6, D6 is 1 when the mark ratio is 5/6 or 6/6, and D6 is A6 when the mark ratio is 2/6 or 4/6.

Fig. 3 is a block diagram under the above code conversion rules described in the Japanese unexamined publication No. 61-58326.

Fig. 4 is a diagram for explaining processing in Fig. 3.

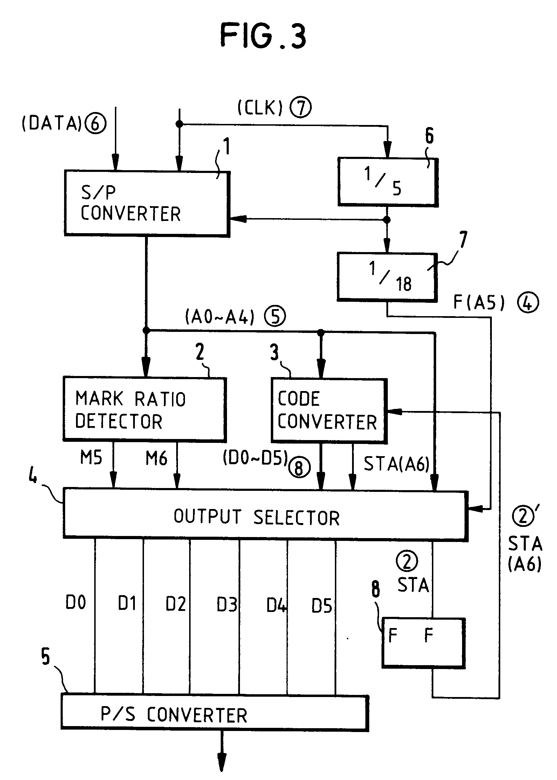

Fig. 3 is an example of mBnB code converting circuit when m = 5, n = 6. The function block has the following elements.

A serial/parallel converting circuit (hereinafter referred to as S/P converting circuit) 1 which converts the serial code data (DATA) ⑥ of 5 bits into the parallel code data ⑤ (indicated as A0 to A4).

A mark ratio detecting circuit 2 which detects the mark ratio (0/5, 1/5, 2/5, 3/5, 4/5, 5/5) depending on the number of "1"'s in the parallel 5 bits code data 5.

A code converter 3 designates a table among a plurality of conversion tables (not illustrated) providing therein the 5 bits code in accordance with content of status bit ②′ (described later in detail), converts such 5 bits code ⑤ to the 6 bits code ⑧ (indicated as D0 to D5) in accordance with the designated code conversion table, and moreover, realizes code conversion only when the mark ratio of 5 bits code ⑤ is 0/5, 1/5, 4/5, 5/5.

An output selection circuit 4 which designates selection of conversion code or nonconversion code of the 5 bits code ⑤ depending on the level "1" (indicating the frame) of the output signal ④ (hereafter referred to as the frame bit F ④ ) from the frequency dividing circuit 7 or level "0" (indicating nonframe) and outputs the information to designate code conversion table within the code converter 3 depending on content of mark ratio of 5 bits code ⑤ as the status bit STA ② .

A P/S converting circuit ⑤ which converts the parallel 6 bits code data D0 to D5 into the serial 6 bits code.

Frequency dividing circuits 6, 7 which divide the input clock ⑦ of the specified period into 1/5 and 1/18 in the frequency in order to set up the conversion timing of S/P conversion circuit 1 and then generate the frame bit F ④ , namely, a frequency dividing circuit 6 outputs a timing signal at which every 5 bits code ⑥ are set in the S/P conversion circuit 1 and a frequency dividing circuit 7 outputs a timing signal when frame bits appearing at every 5x18 bits are set in the S/P conversion circuit 1.

A flip-flop circuit 8 (hereinafter referred to as F.F.) which latches the status bit STA ② preset in the output selection circuit 4.

The mark ratio of output 6 bits code D0-D5 is set to any of 2/6, 3/6, or 4/6.

The code converter 3 provides therein a plurality of conversion tables not illustrated and converts the 5 bits code ⑤ into 6 bits code ⑧ based on the conversion table as indicated in Fig. 1.

This conversion table converts input 5 bits code ⑤ to 6 bits code having mark ratio 5 of 2/6 or 4/6 after the code conversion.

For example, when the mark ratio of input 5 bits ⑤ is 1/5, the conversion table which shows the mark ratio 4/6 after the code conversion is selected. In this timing, the status bit STA ② is renewed to select a conversion table showing the mark ratio 2/6 so that the mark ratio of the next 6 bits code ⑧ has the mark ratio 2/6.

Namely, when the mark ratio of 5 bits code ⑤ is 0/5, 1/5, 4/5, 5/5, the conversion table explained previously is designated by the content of status bit ② ′ which is latched by F.F. 8 for the timing in the code converter 3 so that the mark ratio after the code conversion becomes alternately 2/6 and 4/6 and the 5 bits code is converted to the 6 bits code through this conversion table.

Simultaneously, the status bit ② ′ sets the information which selects and designates the conversion table showing the other mark ratio (for instance, when the mark ratio is 2/6, it is changed to 4/6) for the next 6 bits code conversion when the mark ratio of data ⑤ , the mark ratio detecting circuit 2 detects a mark ratio of data ⑤ any of 0/5, 1/5, 4/5 or 5/5.

The status bit STA ② mentioned above is displayed by the code A6 before the code conversion or D6 after the code conversion as indicated in Fig. 1.

This status bit STA ② is set into the output selection circuit 4 when the mark ratio of data ⑥ is detected as 0/5, 1/5, 4/5, 5/5, after updating content thereof and when the mark ratio is 2/5 or 3/5, the preceding content is directly held.

The status bit STA ② set in the output selection circuit 4 is once latched by F.F. 8, such latch data (STA) ② ′ is fed back to the code converter 3, it is used for code conversion of data ⑤ .

The status bit STA ② ′ is matched in timing with the input data ⑤ since it is latched by F.F. 8.

Next, when the mark ratio of 5 bits signal input ⑤ is 2/5, the bit "1" is added as the final bit to the 5 bits code in order to form the 6 bits code. When the mark ratio is 3/5, the bit "0" is added as the final bit to the 5 bits code. In this case, the mark ratio is changed to 3/6, and such 6 bits code is transmitted to the output selection circuit 4 with the status bit STA ② being latched to the F.F. 8.

The input data (DATA) train ⑥ is applied to the S/P converting circuit 1 together with the clock (CLK) ⑦ and moreover, the signal obtained by dividing the frequency of clock (CLK) ⑦ to 1/5 by the frequency dividing circuit 6 is also applied as the conversion timing signal of the S/P converting curcuit 1.

The input data (DATA) ⑥ is converted to parallel data in every bit of 5 bits (A0 to A4). The mark ratio detecting circuit 2 detects the mark ratio of 0/5 to 5/5 by checking a number of bit "1" in the 5 bits (A0 to A4) code data ⑤.

The left side of Fig. 1 indicates a structure of the input data (DATA) train ⑥, while A0 to A4 indicate the bits 5B5 to 5B1 of 5B code, A5 indicates the frame bit F 4 (generated as the signal having the frequency of 1/18 of the frequency dividing circuit 7) and A6 indicates the status bit STA 2.

The mark ratio detecting circuit 2 displays detected mark ratio by appling to the output selection circuit 4 the detection signals M5 = 0, M6 = 0 when the mark ratio of 5 bits (A0 to A4) code data ⑤ is 2/5, or the detection signals M5 = 0, M6 = 1 when the mark ratio is 3/5, or detection signals M5 = 0, M6 = 0 when the mark ratio is other values.

The output selection circuit 4 controls to select the data ⑧ (D0 to D5) converted by the code converter 3 or the non-converted data ⑤ (A0 to A4) with the signal (A5) ④ (Frame bit F) sent from the 1/18 frequency dividing circuit 7.

The signal (A5) ④ (frame bit F) controls the ouput selection circuit 4 in such a manner as selecting and outputting the parallel signals D0 to D5 converted by the code converter 3 when the bit is "0" or non-converted data ⑤ (A0 to A4) when the bit is "1".

Namely, the frame bit F of signal (A5) ④ controls the output selection circuit 4 to once select the non-converted (in the timing of "1") data ⑤ (A0 to A4) in every 18 words. The mark ratio detected in this timing is invalidated and the status bit ② is held as it is.

The 6 bits code signals D0 to D5 are converted to the 6 bits code output from the output selection circuit 4 and are applied to the P/S converting circuit for conversion to the serial signals.

As explained above, the code consisting of continuous zero's can be suppressed by converting the input data ⑥ (digital signal) to the digital signal with mark ratio of 1/2 with each function block 1 to 8.

Such function blocks 1 to 8 are formed by various kinds of logic circuits and therefore each block is integrated by the one chip of gate array circuit.

The code conversion processing explained above tends to be required to assure high processing rate.

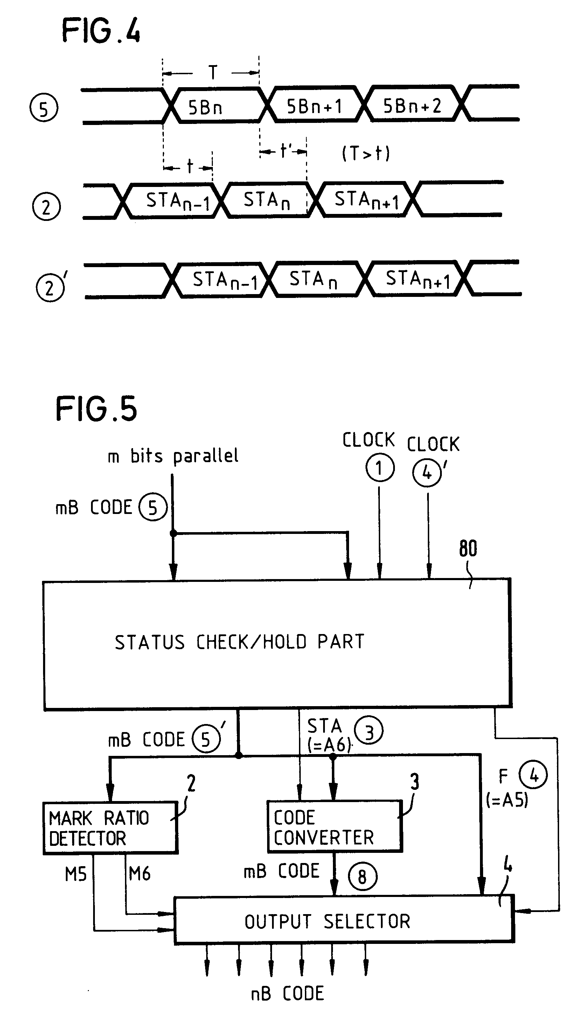

However, for instance, in case of the processing of the prior art as shown in Fig. 4, when the period of input data (DATA) of 5B code is assumed as T and the loop back time for matching the timing by latching the status bit ② as t, T and t must be in the relation as T > t.

In addition, there is a circuit delay t′ for the code converter 3 to output a status bit STA(A6), so that the period of an input data ⑤ T, corresponding to a bit rate of an input data ⑥ , is restricted by the circuit delay t′+ the loop back time t.

Therefore, both a bit rate of an input data ⑥ and processing speeds of the function blocks 1 to 8 depend on the loop back time t.

### Summary of the Invention

Therefore, it is an object of this invention to provide a mBnB converter which is free from the restriction by such a loop back time, so that it is possible to increase the operating speed of a mBnB code conversion up to the maximum limit frequency of a gate array forming an mBnB code converting circuit.

According to one aspect of the present invention, there is provided an mBnB code converting circuit which converts an input m bits data into an n bits code [m<n, n, m are integers], comprising a mark ratio detection circuit for detecting a mark ratio of the input m bits data, a code converter comprising a plurality of code conversion tables, accessed by the input m bits data, for selecting the n bits code so that a mark ratio of the output n bits code becomes a specified value, an output selection circuit for selecting and outputting the output n bits code of said code converter or the input m bit data depending on the value of a frame bit, the output n bit code, when outputted by the output selection circuit, having a mark ratio dependent on the detected mark ratio of said mark ratio detection circuit, and a status check/hold means for also detecting a mark ratio of said input m bits data, setting a status bit for selecting one of the code conversion tables in said code converter in accordance with condition of the mark ratio detected by said status check/hold means, holding said m bits data until content of the status bit is checked and transmitting said m bits data being held together with said checked status bit to the mark ratio detection circuit, said code converter and output selection circuit and also transmitting said frame bit to the output selection circuit.

According to another aspect of the present invention, there is provided an mBnB code converting circuit which decodes and input n bit code into an m bit data [m<n,m, n are integers], comprising a mark ratio detection circuit for detecting a mark ratio of the input n bits code, a decoder comprising a plurality of code conversion tables, accessed by the input n bits code, for selecting the m bits data so that a mark ratio of the output m bits data becomes a specified value, an output selection circuit for selecting and outputting the output m bits data of said decoder or the input n bits data depending on the value of a frame bit, the output m bit code, when outputted by the output selection circuit, having a mark ratio dependent on the detected mark ratio of said mark ratio detection circuit, and a status check/hold means for also detecting a mark ratio of said input n bits code, setting a status bit for selecting one of the code conversion tables in said decoder in accordance with condition of said mark ratio detected by said status check/hold means, holding said n bits code until content of the status bit is checked and transmitting said n bits code being held together with said checked status bit to the mark ratio detection circuit, said decoder and output selection circuit and also transmitting said frame bit to the output selection circuit.

### Brief Description of the Drawings

Fig. 1 indicates the tables for explaining conversion from the 5B code to 6B code,
Fig. 2 indicates the tables for explaining conversion from 6B code to 5B code,
Fig. 3 is a block diagram for explaining the prior art;
Fig. 4 indicates the waveforms for explaining the processing conditions in the prior art;
Fig. 5 is a block diagram for explaining the principle of the present invention;

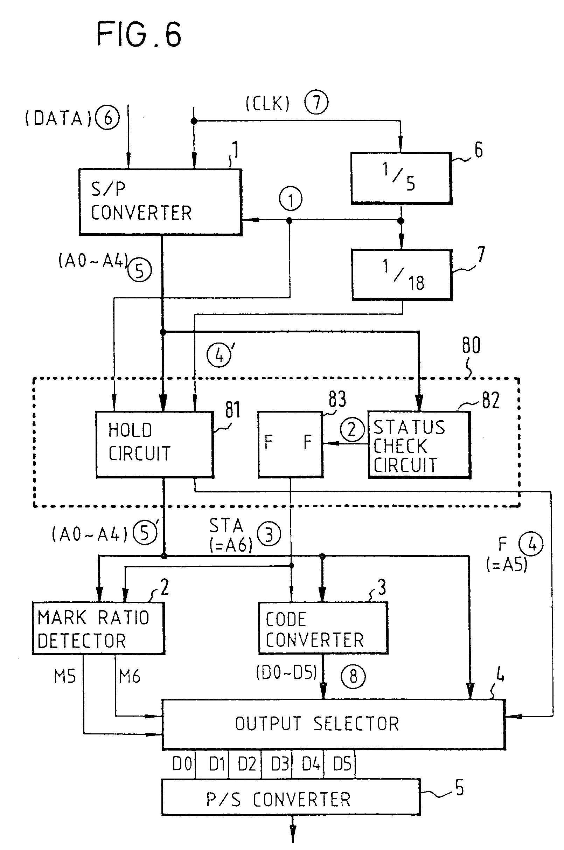

Fig. 6 is a block diagram for explaining the embodiment of the present invention;

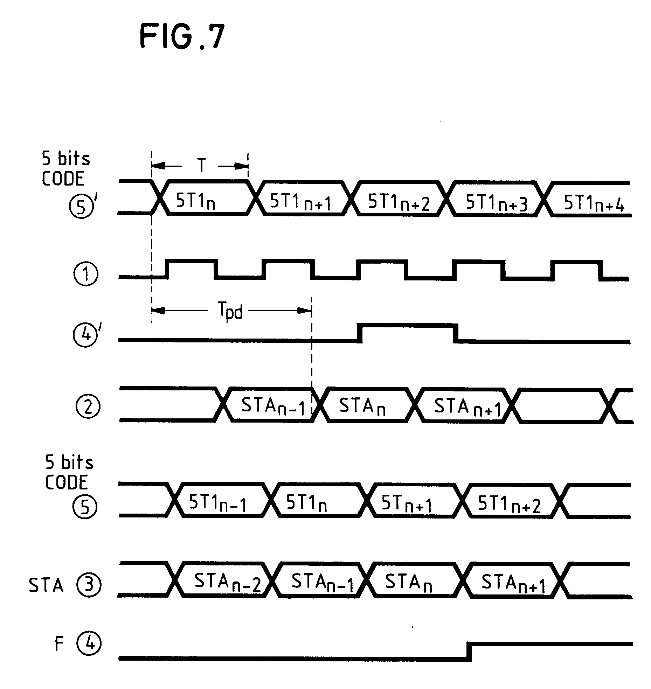

Fig. 7 indicates the waveforms for indicating processing conditions in the embodiment of the present invention;

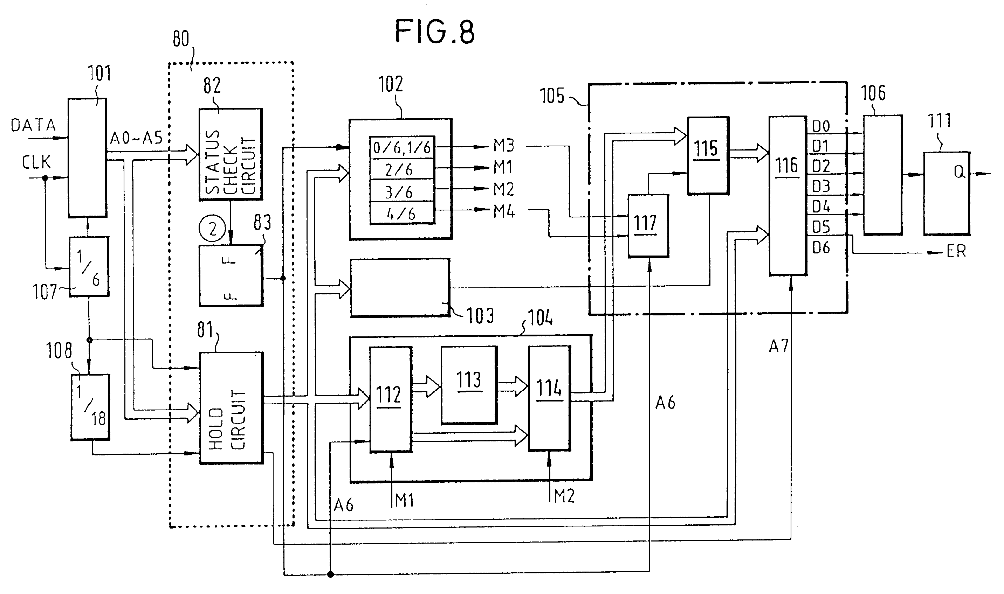

Fig. 8 is a block diagram of an embodiment of the present invention,

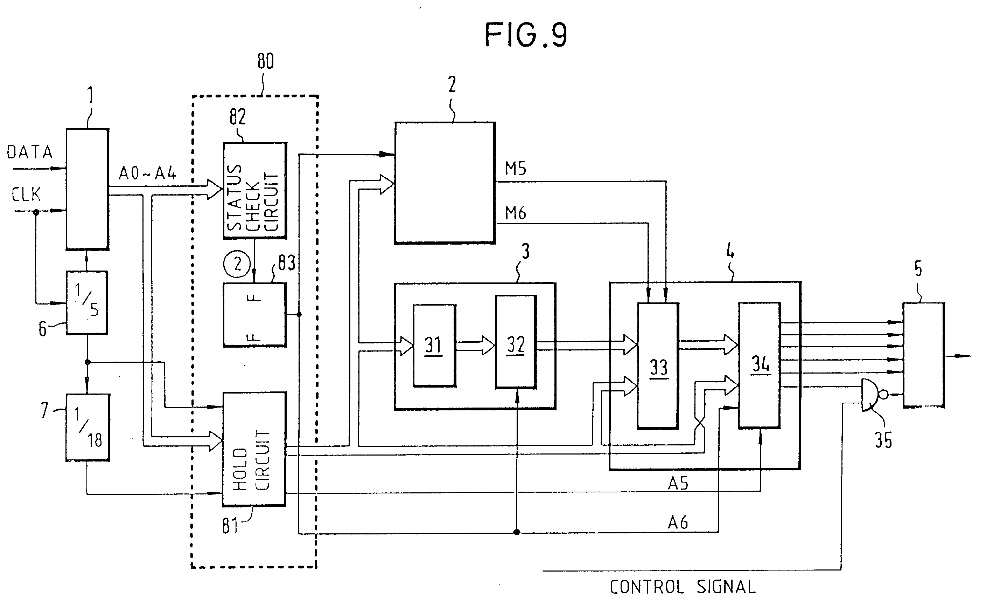

Fig. 9 is a block diagram of another embodiment of the present invention.

### Description of the preferred embodiments

Fig. 5 is a block diagram for explaining the principle of the present invention mBnB code converter for converting an mB code to an nB code.

The principle block diagram of the present invention shown in Fig. 5 comprises the function blocks 2 to 4 explained in Fig. 3 and the status bit check/hold part 80 providing the following functions.

Namely, the status bit check/hold part 80 of the present invention is provided in the preceding stage of the mark ratio detector 2 which detects the mark ratio of parallel signal ⑤ of mB code converted by the S/P converter and the code converter which converts the parallel signal ⑤ of mB code into the nB code, and comprises a means having therein the function to detect the mark ratio of m bits code signal and setting the status bit for selecting and detecting the code conversion table in the code converter 3 in accordance with the condition of detected mark ratio, and a means for holding the m bits code signal until check of content of preset status bit is completed.

A reverse converter for converting an nB code to an mB code has almost the same structure.

The status bit check/hold part 80 is provided in the preceding stage of the mark ratio detector 2 and code converter 3 and is formed so that the input data ⑤ is held in parallel with setting of the status bit ③ by checking the mark ratio of input data ⑤ during this period and these are simultaneously input to the mark ratio detector 2 and code converter 3. Thereby, limitation on the conversion rate of input data ⑤ by the loop back period for checking the status bit 3 is eliminated and operation rate can be increased up to the maximum limit frequency of logic gate array forming each block 2 to 4 and the status bit check/hold part of the mBnB code converting circuit.

Fig. 6 is a block diagram for explaining embodiment of the present invention and Fig. 7 indicates waveforms for explaining processings in the embodiment of the present invention. The like elements are given the like numerals throughout the drawings.

The embodiment of the present invention will be explained based on an example of the 5B6B code converting circuit which converts the 5B (5 bits) code data ⑤ into the 6 bits code data and vice versa.

The status bit check/hold part 80 of the embodiment comprises the following elements.

A hold circuit 81 which holds the 5B code data ⑤ (A0 to A4) for the specified period.

A status check circuit 82 which has the function similar to that of the mark ratio detecting circuit 2 and code converter 3, sets the signal ② in accordance with the mark ratio check result and checks and extracts content of this signal ②.

A flip-flop F.F. 83 which latches the signal ② and sends it to the code converter 3 as the status bit STA ③ simultaneously with the output of hold circuit 81.

The S/P converting circuit 1 respectively sends the parallel data ⑤ as long as 5 bits of input data ⑥ (for instance, 5T1n - 1 indicated in Fig. 7) to the hold circuit 81 and status check circuit 82.

The status check circuit 82 sets the signal ② having the content (information to select and designate the code conversion table not illustrated within the code converter 3) depending on the condition of mark ratio in case the mark ratio is 0/5, 1/5, 4/5, 5/5 of the parallel data ⑤ (5T1n - 1) and causes F.F. 83 to latch such content by checking it.

During this period, the hold circuit 81 holds the parallel data ⑤ (for instance, 5T1n indicated in Fig. 3) continuously input thereto.

The hold circuit 81 holds the parallel data ⑤ in synchronization with the signal ① obtained by dividing the frequency of clock CLK ⑦ to 1/5. Moreover, the signal ④ ′ (called the frame pulse) obtained by dividing the frequency of clock CLK ⑦ to 1/18 is also sent to the hold circuit 81.

This frame pulse ④′ is once output in every 18 words as explained previously. This pulse is sent from the hold circuit 81 and becomes the signal ④ (frame pulse F) which controls the output selection circuit 4.

A number of bits held in the hold circuit 81 is determined depending on delay amount of status check circuit 82. For example, when such delay amount is assumed as Tpd and period of the data ⑤ (period of 5T1n, etc. as indicated in Fig. 7) as T, a number of delayed bits in the hold circuit 81 is indicated by Tpd/T (where, fraction is emitted).

With such delay adjustment, the status bit STA ③ is sent simultaneously to the mark ratio detecting circuit 2 and code converter 3 under the condition that it is synchronized in the phase with the next parallel data as indicated in Fig. 7.

Under the condition that the frame bit F ④ is "0", the 6 bits code data signals ⑧ (D0 to D5) having the mark ratio of 2/6 or 4/6 which has been converted, by the code converter 3, from the 5 bits code data signals 5′ (A0 to A4) sent from the hold circuit 81 based on the code conversion table (not illustrated) selected depending on designation of status bit STA 3 are selected in the selection output circuit 4 and are then sent to the P/S converting circuit 5.

As explained previously, since mBnB code conversion can be realized without depending on delay amount of the mark ratio detection circuit 2, code converter 3 and output selection circuit 4, similar code conversion can also be realized easily even in the code conversion circuit having a high bit rate.

Fig. 8 is a block diagram of an embodiment of the present invention wherein the 6B code is converted to the 5B code in the converting circuit. In this figure, 101 is a serial to parallel converter, 102 is a mark ratio detector, 103 is a code rule detector, 104 is a code converter; 105 is a selection output; 106 is a parallel to serial converter; 107 and 108 are frequency dividing circuits; 111 is a flip-flop for output; 112 and 114 are selection circuits; 113 is a decoder; 115 and 116 are selection circuits; 117 is a status bit setting circuit.

The input data DATA is applied to the serial to parallel converter 101 with the clock signal CLK, the clock signal CLK is divided to 1/6 in frequency by the frequency dividing circuit 107 and is applied to the serial to parallel converter 101 as the conversion timing signal. The input data DATA is applied, in parallel in every bit of 6 bits A0 to A5 to both the status check circuit 82 and the hold circuit 81 as explained with Fig. 6. Operations of status check and hold circuit 80 are same as that of Fig. 6.

The hold circuit outputs a 6 bits parallel data to the selection circuit 112, the code rule detector 103 and the mark ratio detector.

Since a mark ratio can be detected in accordance with a number of bits "1" in the six bits A0 to A5, the mark ratio detector 102 is formed by a decoder. M1 is a detection signal with mark ratio 2/6, M2 is a detection signal with mark ratio 3/6, M3 is a detection signal with mark ratio 1/6 and M4 is a detection signal of mark ratio 4/6. The detection signal M1 is applied to the selection circuit 112, while the detection signal M2 to the selection circuit 112, the detection signals M3, M4 to the status bit setting circuit 117, respectively.

The mark ratio of 6B code is set to any of 2/6, 3/6 or 4/6 and in case it is set to a value other than these, it does not match the code rule. Therefore, the code rule detector 103 can be formed by a decoder similar to that for detecting the mark ratio. When the detection signal is applied to the selection circuit 115 matching the code rule, an output signal of code converter 104 is selectively output. When detection signal does not match the code rule, the status bit STA (D6) sent from the status bit setting circuit 117 is selectively output and simultaneously the error bit ER (D5) is output.

In the code converter 104 a detection signal M1 is applied to the selection circuit 112 from the mark ratio detector 102 When the mark ratio is 2/6, the six bits A0 to A5 are inversely output but are directly output in other cases. Namely, the code converter can be formed by an inverter and a switch gate. The decoder 113 provides a structure for 5B6B inverse conversion when the mark ratio is 4/6. Since the 6B code with mark ratio 2/6 is formed by inverting the 6B code when the mark ratio is 2/6, the 6B code with mark ratio 2/6 and 4/6 is converted to the 5B code by the decoder 113. For instance, the code "010010" with mark ratio 2/6 is inverted to "101101" and these bits are decoded to the 5B code of "01111".

The selection circuit 114 selectively outputs the output signal of selection circuit 112 with the detection signal M with mark ratio 3/6 and selectively outputs the output signal of decoder 113 when the mark ratio takes the other value. Namely, in case the mark ratio is 3/6, it corresponds to formation of 6B code by adding "1" or "0" to the 5B code. Therefore, since the 6B code can be converted to 5B code by eliminating the lowest bit of 6B code, the parallel six bits A0 to A5 are selectively output.

In the selection output 105 the output signal of selection circuit 114 of code converter 104 is applied to the selection circuit 115 the status bit STA sent from the status bit setting circuit 117 is also applied thereto. Therefore, when the input data DATA matches the code rule, the detection signal is applied to the selection circuit 115 from the code rule detector 103 and the selection circuit 115 selectively outputs the selection output of the selection circuit 114. In case the input data DATA does not match the code rule, the selection circuit 115 selectively outputs the status bit STA and error pattern sent from the status bit setting circuit 117 The selection output signal of selection circuit 115 is applied to the selection circuit 115 with the parallel signal sent from the serial to parallel converter 101 and the selection circuit 115 executes the selecting operation with the input A7 (frame bit F) of the output signal of the hold circuit 81. In the case of frame, outputs can be selectively obtained for respective inputs as indicated by D0 = A1, D1 = A2, D2 = A3, D3 = A4, D4 = A5, D5 = 0 and D6 = A6, however, in the case of nonframe, the selective output signals D0 to D6 of the selection circuit 115 can be selectively obtained.

In the parallel to serial converter 106, the 5 bits D0 to D4 sent from the selection output 105 are converted to the serial signal and are then output through the flip-flop 111. Thereby, the bit D5 becomes the error bit ER.

As explained heretofore, since each part can be formed by the logic circuits, it is certainly formed by the gate array circuit and the converting circuit which converts the 6B code to 5B code can be realized on the one chip integrated circuit.

Fig. 9 is a block diagram of another embodiment of the present invention indicating the converting circuit which converts the 5B code to 6B code. In this figure, the same numeral with Fig. 6 indicates the same parts and 31 is a decoder, 32 and 34 are selection circuits and 35 is a NAND circuit.

To the serial to parall el converter 1, both input data DATA and clock signal CLK are applied, the clock signal CLK is divided into 1/5 in the frequency by the frequency dividing circuit 6, this signal is then applied to the serial to parallel converter 1 as the conversion timing signal and the input data DATA is converted to parallel signal in every bit of 5 bits A0 to A4. The mark ratio detector 2 detects the mark ratio of the 5 bits A0 to A4. When the mark ratio is 2/5, the detection signals M5 = 0, M6 = 0 are applied to the section circuit 33, while the detection signals M5 = 0, M6 = 1 when the mark ratio is 3/5 and the detection signals M5 = 0, M6 = 0 in other cases.

In the code converter 3, the 5 bits A0 to A5 are converted by the decoder 31 to the 6B code and are then applied to the selection circuit 32. This selection circuit 32 realizes the selecting operation with the output signal A6 of the flip-flop 83. Since this signal A6 indicates disparity, when it is "1", an output signal of the decoder 31 is directly selected as the output and when it is "0", an output signal of the decoder 31 is output inversely.

The selection output 4 controls the selection circuit with the mark ratio detection signals M5, M6. When the mark ratio is 2/5 or 3/5, the selection output selectively outputs the parallel signal from the hold circuit 81. When the mark ratio is other values, the selection output selectively outputs an output signal of the code converter 3. The selection circuit 34 is controlled by the output signal A5 of the hold circuit. Since this signal A5 indicates the frame bit F, when it is "1" indicating the frame, the parallel signal of the serial to parallel converter 1 is selectively output, while when it is "0" indicating nonframe, the selected output signal of selection circuit 33 is selectively output. The 5 bits D0 to D4 among the selection output signals D0 to D6 of the selection circuit 34 are directly applied to the parallel to serial converter 5. The bit D5 is applied to the NAND circuit 35, a control signal sent from the multiplexer not illustrated is applied to such NAND circuit 35. Moreover, the parallel 6B code signal is converted to the serial signal and is then output by the parallel to serial converter 5.

As explained previously, since each part is formed by the logic circuits, the converting circuit can also be integrated by the one chip gate array circuit.

In the above embodiment, the 5B6B code converting circuit has been explained by such converting circuit may be realized with the gate array circuit of about 1000 gates. Moreover, the present invention can certainly be adopted to the mBnB code converting circuit where m and n are selected freely.

## Claims

1. An mBnB code converting circuit which converts an input m bits data into an n bits code [m<n, n, m are integers], comprising:
a mark ratio detection circuit (2) for detecting a mark ratio of the input m bits data,
a code converter (3) comprising a plurality of code conversion tables, accessed by the input m bits data, for selecting the n bits code so that a mark ratio of the output n bits code becomes a specified value,
an output selection circuit (4) selecting and outputting the output n bits code of said code converter (3) or the input m bit data depending on the value of a frame bit, the output n bit code, when outputted by the output selection circuit, having a mark ratio dependent on the detected mark ratio of said mark ratio detection circuit (2), and
a status check/hold means (80) for also detecting a mark ratio of said input m bits data, setting a status bit for selecting one of the code conversion tables in said code converter (3) in accordance with condition of the mark ratio detected by said status check/hold means (80), holding said m bits data until content of the status bit is checked and transmitting said m bits data being held together with said checked status bit to the mark ratio detection circuit (2), said code converter (3) and output selection circuit (4) and also transmitting said frame bit to the output selection circuit (4).

2. An mBnB code converting circuit which decodes and input n bit code into an m bit data [m<n,m, n are integers], comprising:
a mark ratio detection circuit (102) for detecting a mark ratio of the input n bits code,
a decoder (113) comprising a plurality of code conversion tables, accessed by the input n bits code, for selecting the m bits data so that a mark ratio of the output m bits data becomes a specified value,
an output selection circuit (105) for selecting and outputting the output m bits data of said decoder (113) or the input n bits data depending on the value of a frame bit, the output m bit code, when outputted by the output selection circuit, having a mark ratio dependent on the detected mark ratio of said mark ratio detection circuit (102), and
a status check/hold means (80) for also detecting a mark ratio of said input n bits code, setting a status bit for selecting one of the code conversion tables in said decoder (113) in accordance with condition of said mark ratio detected by said status check/hold means (80), holding said n bits code until content of the status bit is checked and transmitting said n bits code being held together with said checked status bit to the mark ratio detection circuit (102), said decoder (113) and output selection circuit (105) and also transmitting said frame bit to the output selection circuit (105).

## Patentansprüche

1. mBnB-Kodeumwandlungsschaltung, welche ein m-Bit-Eingangsdatensignal in einen n-Bit-Kode umwandelt [wobei m < n ist und n, m ganze Zahlen sind] mit:
einer Zeichenverhältnis-Detektionsschaltung (2) zur Detektion eines Zeichenverhältnisses der m-Bit-Eingangsdaten,
einem Kodewandler (3), welcher mehrere Kodeumwandlungstabellen aufweist, auf die von dem m-Bit-Eingangsdatensignal zugegriffen wird, um den n-Bit-Kode so zu selektieren, daß ein Zeichenverhältnis des n-Bit-Ausgangskodesignals einen spezifischen Wert annimmt,
einer Ausgangsselektionsschaltung (4) zum Selektieren und Ausgeben des n-Bit-Ausgangskodesignals des Kodewandlers (3) oder des m-Bit-Eingangsdatensignals in Abhängigkeit von dem Wert eines Rahmenbits, wobei der n-Bit-Ausgangskode, wenn es von der Ausgangsselektionsschaltung ausgegeben wird, ein von dem detektierten Zeichenverhältnis der Zeichenverhältnis-Detektionsschaltung (2) abhängiges Zeichenverhältnis aufweist, und
einer Status-Prüf/Halte-Einrichtung (80), um ebenfalls ein Zeichenverhältnis des m-Bit-Eingangsdatensignals zu detektieren, um ein Statusbit zu setzen, um eine der Kodeumwandlungstabellen in dem Kodewandler (3) abhängig von dem Zustand des von der Status-Prüf/Halte-Einrichtung (80) detektierten Zeichenverhältnisses zu selektieren, um das m-Bit Datensignal zu halten, bis der Inhalt des Statusbits geprüft ist, und um die gehaltenen m-Bit-Daten zusammen mit dem geprüften Statusbit an die Zeichenverhältnis-Detektionsschaltung (2), den Kodewandler (3) und die Ausgangsselektionsschaltung (4) zu übertragen und um ebenfalls das Rahmenbit an die Ausgangsselektionsschaltung (4) zu übertragen.

2. mBnB-Kodeumwandlungsschaltung, welche ein n-Bit-Eingangskodesignal in ein m-Bit-Datensignal dekodiert [wobei m < n ist und m, n ganze Zahlen sind] mit:
einer Zeichenverhältnis-Detektionsschaltung (102) zur Detektion eines Zeichenverhältnisses des n-Bit-Eingangskodesignals,
einem Dekoder (113), welcher mehrere Kodeumwandlungstabellen aufweist, auf die vom dem n-Bit-Eingangskodesignal zugegriffen wird, um die m-Bit-Datensignale so zu selektieren, daß ein Zeichenverhältnis des m-Bit-Ausgangsdatensignals einen spezifischen Wert annimmt,
einer Ausgangsselektionsschaltung (105) zum Selektieren und Ausgeben des m-Bit-Ausgangsdatensignals des Dekoders (113) oder des n-Bit-Eingangsdatensignals in Abhängigkeit von dem Wert eines Rahmenbits, wobei das m-Bit-Ausgangskodesignal, wenn es von der Ausgangsselektionsschaltung ausgegeben wird, ein von dem detektierten Zeichenverhältnis der Zeichenverhältnis-Detektionsschaltung abhängiges Zeichenverhältnis aufweist, und einer Status-Prüf/Halte-Einrichtung (80), um ebenfalls ein Zeichenverhältnis des n-Bit-Eingangskodesignals zu detektieren, um ein Statusbit zu setzen, um eine der Kodeumwandlungstabellen in dem Dekoder (113) abhängig von dem Zustand des von der Status-Prüf/Halte-Einrichtung (80) detektierten Zeichenverhältnisses zu selektieren, um das n-Bit-Eingangskodesignal zu halten, bis der Inhalt des Statusbits geprüft ist, und um das gehaltene n-Bit-Kodesignal zusammen mit dem geprüften Statusbit an die Zeichenverhältnis-Detektionsschaltung (102), den Dekoder (113) und die Ausgangsselektionsschaltung (105) zu übertragen und um ebenfalls das Rahmenbit an die Ausgangsselektionsschaltung (105) zu übertragen.

## Revendications

1. Circuit de conversion de code de m bits en n bits qui convertit une entrée de données de m bits en code à n bits [m<n, n, m sont des entiers], comprenant :
un circuit de détection de rapport de marque (2) pour détecter un rapport de marque des données d'entrée à m bits,
un convertisseur de code (3) comprenant une pluralité de tables de conversion de code, auxquelles on accède par les données à m bits, pour sélectionner le code à n bits de sorte qu'un rapport de marque du code de sortie de n bits devient une valeur spécifiée.
un circuit de sélection de sortie (4) pour sélectionner et fournir le code de sortie à n bits dudit convertisseur de code (3) ou les données d'entrées à m bits en fonction de la valeur d'un bit de trame, le code de sortie de n bits, lorsqu'il est fourni par le circuit de sélection de sortie, ayant un rapport de marque dépendant du rapport de marque détecté par ledit circuit de détection de rapport de marque (2), et
un dispositif de contrôle et de maintien d'état (80) pour détecter aussi un rapport de marque desdites données d'entrée de m bits, régler un bit d'état pour sélectionner une des tables de conversion de code dans ledit convertisseur de code (3) en fonction de l'état du rapport de marque détecté par ledit dispositif de contrôle et de maintien d'état (80), maintenir lesdites données de m bits jusqu'à ce que le contenu du bit d'état soit contrôlé et transmettre lesdites données à m bits ayant été maintenues ensemble avec ledit bit d'état contrôlé au circuit de détection de rapport de marque (2), ledit convertisseur de code (3) et le circuit de sélection de sortie (4) et transmettre aussi ledit bit de trame au circuit de sélection de sortie (4).

2. Circuit de conversion de code de m bits en n bits qui décode un code d'entrée de n bits en des données de m bits [m<n, m, n sont des entiers], comprenant :
un circuit de détection de rapport de marque (102) pour détecter un rapport de marque du code d'entrée à n bits,
un décodeur (113) comprenant une pluralité de tables de conversion de code, auxquelles on accède par le code d'entrée à n bits, pour sélectionner les données à m bits de sorte qu'un rapport de marque des données de sortie à m bits devient une valeur spécifiée,
un circuit de sélection de sortie (105) pour sélectionner et fournir les données de sortie à m bits dudit décodeur (113) ou les données d'entrées à n bits en fonction de la valeur d'un bit de trame, la sortie du code à m bits, lorsqu'elle est fournie par le circuit de sélection de sortie, ayant un rapport de marque dépendant du rapport de marque détecté par ledit circuit de détection de rapport de marque (102), et
un dispositif de contrôle et de maintien d'état (80) pour détecter aussi un rapport de marque dudit code d'entrée à n bits, régler un bit d'état pour sélectionner une des tables de conversion dans ledit décodeur (113) en fonction de l'état dudit rapport de marque détecté par ledit dispositif de contrôle et de maintien d'état (80), maintenir ledit code à n bits jusqu'à ce que le contenu du bit d'état soit contrôlé et transmettre ledit code à n bits maintenu ensemble avec ledit bit d'état contrôlé au circuit de détection de rapport de marque (102), ledit décodeur (113) et le circuit de sortie de sélection (105) et également transmettre ledit bit de trame au circuit de sortie de sélection (105).
